# EUROPEAN PATENT SPECIFICATION

(11) **EP 0 379 738 B1**
(45) Date of publication and mention of the grant of the patent: **10.12.1997**
(21) Application number: 89124157.2
(22) Date of filing: 29.12.1989
(51) Int. Cl.: G02B 1/10, C23C 14/46, C03C 17/245, C03C 17/34

(54) **Laser coupled to an optical layer of Ta2O5**
Laser und eine damit gekoppelte optische Schicht aus Ta2O5
Laser couplé à une couche optique de Ta2O5

(30) Priority: 23.01.1989 US 299761; 15.11.1989 US 437697
(43) Date of publication of application: 01.08.1990
(73) Proprietor: BALZERS AKTIENGESELLSCHAFT, 9496 Balzers (LI)
(72) Inventor: Kügler, Eduard, Dr., A-6807 Feldkirch Tisis (AT); Pfefferkorn, Roland, A-6807 Feldkirch Tisis (AT)
(74) Representative: Troesch, Jacques J., Dr. sc. nat.

(56) References cited:
- GB-A- 1 416 097
- GB-A- 2 002 581
- US-A- 4 372 987
- THIN SOLID FILMS, vol. 30, 1975, pages 361-369, Lausanne, CH; E.E. KHAWAJA et
- al.: "The optical properties of thin films of tantalum pentoxide and zirconium dioxide"
- IDEM
- IDEM
- APPLIED OPTICS, vol. 24, no. 4, 15th February 1985, pages 490-494, New York, US; H. DEMIRYONT et al.: "Effects of oxygen content on the optical properties of tantalum oxide films deposited by ion-beam sputtering"
- SOVIET JOURNAL OF QUANTUM ELECTRONICS, vol. 18, no. 10, October 1988, pages 1286-1290, Woodbury, NY, US; B. BRAUNS et al.: "Optical coatings for high power neodymium lasers"
- W.G. DRISCOLL: "Handbook of Optics", 1978, pages 10-3 - 10-6, McGraw-Hill, New York, US
- Journal of Vacuum Science and Technology A, Second Series, Vol.3, No.3, Part I, May/June 1985, page 656; J R SITES et al., "Ion-beam sputter deposition of oxide films"
- Review of Scientific Instruments Vol.59, No.10, October 1988, pages 2177-2184; R A FERRIERI et al, "Ion sputtering on metal oxides: A source of translationally hot O(3Pj) atoms for chemical studies above 1 eV"
- Radiation Effects Vol.19 (1973) UK, pages 39-48; R KELLY et al., "The sputtering of oxides. Part I: A survey of the experimental results"

## Description

The present invention is directed to an apparatus as defined by the generic part of claim 1.

It is well-known that especially for high energy laser applications, absorption of energy by optical elements must be kept as low as possible so that such elements withstand the high energy density.

From "Soviet Journal of Quantum Electronics", Vol. 18, No. 10, October 1988, Woodbury, New York, US, pages 1286 - 1290; B. Brauns et al.: "Optical coatings for high power neodymium lasers" it is known an apparatus with a high-power neodymium laser emitting at 1,06 µm cooperating with a laser resonator mirror with a multilayer interference coating. The coatings are made of Ta₂0₅, Zr0₂ and Hf0₂ on one hand, on the other hand of Si0₂.

From the US-A-4 142 958, layers of a quarter wavelength thickness of 500 - 800 Å are known, thus for applications for light within the ultra-red region. This layers are reported to present losses in the range of 0.01% for that ultra-red light and are made of a high index material as of tantalum pentoxide or titanium dioxide. These layers are made according to this document by a reactive ion-beam sputtering process whereby titanium dioxide layers are reported to be made by sputtering a titanium dioxide target. Thus for ultra-red applications quarter wave-length layers of Ta₂O₅ are known from that document with losses in the range of 0.01%.

From F. Rainer et al "Materials for optical coatings in the ultra-violet", Applied Optics, Vol. 24, No. 4 / 15 February 1985, page 496 ff., it is known to use coating materials as ZrO₂, Y₂O₃, HfO₂, Sc₂O₃, MgO, Al₂O₃, SiO₂ for light in the ultra-violet region at 248nm. Thereby the coatings which are subjected to investigation are deposited by electron beam evaporation. For light at 248nm, an extinction coefficient was measured below 0.01.

According to H. Demiryont et al "Effects of oxygen content on the optical properties of tantalum oxide films deposited by ion-beam sputtering", Applied Optics, Vol. 24, No. 4 / 15 February 1985, page 490 ff., it has been found that tantalum pentoxide layers have an extinction coefficient of approximately 0.02 at 300nm light dropping to about 0.01 at 310nm and dropping then asymptotically towards 10⁻³ at about 375nm. The layers which are investigated by Demiryont are produced by ion-beam sputtering technique as e.g. described in J.M.E. Harper et al "Technology and applications of broad-beam ion sources used in sputtering", Part II, Applications, J. Vac.Sci. Technol., 21(3), Sept./Oct. 1982, page 737, and in J.L. Vossen et al "Thin film processes", Academic Press Inc., New York 1978, page 175.

The layers which were investigated by Demiryont were produced by using a target of metallic tantalum.

Thus the investigation of Demiryont clearly reveals that tantalum pentoxide may not be used for high energy density applications of light below 350nm, because the extinction coefficient of 0.01 at 310nm settles an extinction coefficient versus wave-length curve which lies above such a curve which would define extinction coefficients between 300nm and 350nm which are small enough. These results fit with the results according to US-A-4 142 958 wherein tantalum pentoxide layers had been reported of still not vanishing extinction coefficient in the ultra-red region, that is for light with wave-length in the micrometer region.

From Journal of vacuum science & technology A, second series, Vol. 3, No. 3, Part I, May/June 1985, page 656; J.R. Sites et al.: "Ion-beam sputter deposition of oxide films" it is known to ion-beam sputter deposite high refractive index TiO₂ and Ta₂O₅ and low index SiO₂. Thereby, an elemental or oxide target is used.

Tantalum pentoxide has several advantages, namely:
- good mechanical and optical stability, being hard and withstanding environmental stress and further forming a very dense layer,
- good plasma stability in that Ta₂O₅ does not change its stoichiometry under plasma conditions,
- extremely low scattering of light,
- withstand very high temperatures.

It is the object of the present invention to widen the scope of laser-based apparatus whereat the advantages of tantalum pentoxide layers are still exploited.

This is resolved by the apparatus as mentioned above and construed according to the characterizing part of claim 1.

Thus an optical layer which is made of at least predominantly Ta₂O₅ and which has significantly lower coefficient of extinction compared with known Ta₂O₅ layers as known from the above mentioned article of Demiryont is used. Accordingly, and due to the high refractive index of tantalum pentoxide, thin multi-layers leading to thin quarter wavelength layers are achieved. Such thin layers are especially useful in dry etching applications.

Thus, apparatus according to the present invention makes use of an optical layer which is at least predominantly of Ta₂O₅ and which has an extinction coefficient which is less than 0.0075 for light of 308nm. This point of the extinction coefficient versus wave-length curve sets the entire curve between 300nm and 350nm significantly below that settled by the 310nm/0.01-point of Demiryont.

Astonishingly the use of an ion-beam sputtering technique as well-known e.g. from Harper or J.L. Vossen mentioned above, but there not applied on a metallic tantalum target, but on a target predominantly made of tantalum pentoxide allows realization of the above mentioned significantly improved Ta₂O₅ layer.

With an ion-beam sputtering technique known to the man skilled in the art and as e.g. described in either Harper et al or J.L. Vossen mentioned above, there was sputtered a target made of at least 99% Ta₂O₅. By this technique there was formed a thin layer on either an SiO₂ or an Al₂O₃ substrate. For light of 300nm the produced layer had an extinction coefficient of 0.0068, for light of 308nm of 0.003, thus providing for a layer which has an extinction coefficient clearly below 0.0075 for light of 308nm.

With Ta₂O₅ layers of such improved extinction coefficient high energy density applications become possible. As the measuring point at 300nm or 308nm sets the extinction coefficient versus wave-length curve, it becomes evident that by this Ta₂O₅ layer a layer is realized with significantly lower extinction coefficient over the 300nm to 350nm wave-length band, making high energy applications possible for light especially in this entire band.

As it was mentioned, this Ta₂O₅ layer comprises predominantly Ta₂O₅. For specific control of its optical characteristics it may further comprise at least one of the following materials: ZrO₂, Y₂O₃, HfO₂, Sc₂O₃, MgO, Al₂O₃, SiO₂. Accordingly and as was mentioned, the target material used is predominantly of Ta₂O₅, but may comprise at least one of the following materials: ZrO₂, Y₂O₃, HfO₂, Sc₂O₃, MgO, Al₂O₃, SiO₂.

Based on the above described improved Ta₂O₅ layer there was further realized an optical element in that there was sputtered from the said target predominantly of Ta₂O₅ a λ/4 Ta₂O₅ layer on a substrate of SiO₂ or Al₂O₃, preferably of SiO₂. Afterwards there was sputtered on said Ta₂O₅ λ/4 layer a further layer of SiO₂ or of Al₂O₃, preferably again of SiO₂, with a thickness of λ/4, thus producing a double layer of Ta₂O₅ and SiO₂ or Al₂O₃.

With Ta₂O₅ and SiO₂ double layers for light of 308nm, seven such double layers of λ/4 each single layer, were sputtered on an SiO₂-substrate providing for an optical element substrate with resulting reflection of approximately 99%.

This optical element made of at least one double layer of two materials on a substrate, one of said two materials being predominantly Ta₂O₅, the other being SiO₂ or Al₂O₃, may Clearly be used especially for high energy density application of light of 308nm or between 300nm and 350nm wave-length and has very small thickness and very low light absorption compared with optical elements of other materials used for such wave-lengths up to now. As the low absorbing layer and optical element allows reflection or transmission of high energy beams, they are combined in apparatus with XeCl excimer lasers, N₂- or HeCd-gas lasers, where such layers and/or optical elements co-operate with the beam of such a laser.

## Claims

1. An apparatus comprising at least one laser and an optical element with at least one layer of Ta₂O₅ optically coupled to said laser, characterized by the facts that
- said laser is one of a HeCd-, N₂-gas- or XeCl-excimer laser, and
- said Ta₂O₅ layer has an extinction coefficient less than 0.0075 for light of a wavelength of 308nm.

2. The apparatus of claim 1, wherein said Ta₂O₅ layer has an extinction coefficient less than 0.005 for light of 308nm wavelength.

3. The apparatus of claim 1, wherein said layer further comprises at least one of the following materials:
- ZrO₂, Y₂O₃, HfO₂, Sc₂O₃, MgO, Al₂O₃, SiO₂.

4. The apparatus of claim 1, wherein said Ta₂O₅ layer is of at least 99% Ta₂O₅.

5. The apparatus of claim 1, wherein said Ta₂O₅ layer has a thickness of λ/4 and said optical element further comprises at least one further layer of λ/4 optical thickness made of a material of lower refractive index than the refractive index of Ta₂O₅ of said layer.

6. The apparatus of claim 5, wherein said laser is a HeCd-or XeCl-laser and wherein said at least two layers are λ/4 for light of 308nm or 325nm wavelength.

7. The apparatus of claim 5, wherein said further layer is made of at least one of SiO₂ and of Al₂O₃.

8. The apparatus of claim 5, wherein said Ta₂O₅ layer and said further layer form a double layer and said optical element comprises at least two of said double layers.

9. The apparatus of claim 8, wherein said optical element comprises at least six double layers and has a reflection of at least 95% for light of 308nm wavelength.

## Patentansprüche

1. Gerät mit mindestens einem Laser und einem optischen Element mit mindestens einer Schicht aus Ta₂O₅, die optisch mit dem Laser gekoppelt ist,
**dadurch gekennzeichnet, daß**
- der Laser ein HeCd-, N₂-Gas- oder XeCl-Excimerlaser ist, und
- die Ta₂O₅-Schicht einen Extinktionskoeffizienten von weniger als 0.0075 für Licht von einer Wellenlänge von 308 nm hat.

2. Gerät nach Anspruch 1, **dadurch gekennzeichnet, daß** die Ta₂O₅-Schicht einen Extinktionskoeffizienten von weniger als 0.005 für Licht mit einer 308 nm Wellenlänge hat.

3. Gerät nach Anspruch 1, **dadurch gekennzeichnet, daß** die Schicht weiter mindestens eines der folgenden Materialien umfasst:
- ZrO₂, Y₂O₃, HfO₂, Sc₂O₃, MgO, Al₂O₃, SiO₂.

4. Gerät nach Anspruch 1, **dadurch gekennzeichnet, daß** die Ta₂O₅-Schicht zu mindestens 99 % aus Ta₂O₅ besteht.

5. Gerät nach Anspruch 1, **dadurch gekennzeichnet, daß** die Ta₂O₅-Schicht eine Dicke von λ/4 hat und das optische Element weiter mindestens eine weitere Schicht mit einer optischen Dicke von λ/4 aufweist, die aus einem Material mit einem niedrigeren Brechungsindex als der Brechungsindex des Ta₂O₅ der Schicht gebildet ist.

6. Gerät nach Anspruch 5, **dadurch gekennzeichnet, daß** der Laser ein HeCd- oder ein XeCl-Laser ist und die mindestens zwei Schichten λ/4-Schichten für Licht von einer Wellenlänge von 308nm oder 325nm aufweisen.

7. Gerät nach Anspruch 5, **dadurch gekennzeichnet, daß** die weitere Schicht aus SiO₂ und/oder Al₂O₃ gebildet ist.

8. Gerät nach Anspruch 5, **dadurch gekennzeichnet, daß** die Ta₂O₅-Schicht und die weitere Schicht eine Doppelschicht bilden und das optische Element mindestens zwei der Doppelschichten umfaßt.

9. Gerät nach Anspruch 8, **dadurch gekennzeichnet, daß** das optische Element mindestens sechs Doppelschichten umfaßt und eine Reflektion von mindestens 95 % für Licht von einer Wellenlänge von 308 nm besitzt.

## Revendications

1. Appareil comprenant au moins un laser et un élément optique ayant au moins une couche de Ta₂O₅, optiquement couplé audit laser, caractérisé en ce que :
ledit laser est un laser à excimères de XeCl, à gaz HeCd ou à gaz N₂, et
ladite couche de Ta₂O₅ a un coefficient d'extinction inférieur à 0,0075 pour une lumière de 308 nm de longueur d'onde.

2. Appareil selon la revendication 1, dans lequel ladite couche de Ta₂O₅ a un coefficient d'extinction inférieur à 0,005 pour une lumière de 308 nm de longueur d'onde.

3. Appareil selon la revendication 1, dans lequel ladite couche contient en outre l'une au moins des matières suivantes :
ZrO₂, Y₂O₃, HfO₂, Sc₂O₃, MgO, Al₂O₃, SiO₂.

4. Appareil selon la revendication 1, dans lequel ladite couche de Ta₂O₅ contient au moins 99% de Ta₂O₅.

5. Appareil selon la revendication 1, dans laquelle ladite couche de Ta₂O₅ a une épaisseur de λ/4 et en ce que ledit élément optique comprend en outre au moins une autre couche d'une épaisseur optique de λ/4 en une matière d'indice de réfraction inférieur à l'indice de réfraction du Ta₂O₅ de ladite couche.

6. Appareil selon la revendication 5, dans lequel ledit laser est un laser à HeCd ou à XeCl et dans lequel lesdites deux couches ont une épaisseur de λ/4 pour une lumière de 308 nm ou 325 nm de longueur d'onde.

7. Appareil selon la revendication 5, dans lequel ladite autre couche est constituée par au moins l'un parmi SiO₂ et Al₂O₃.

8. Appareil selon la revendication 5, dans lequel ladite couche de Ta₂O₅ et ladite autre couche forment une double couche et ledit élément optique comprend au moins deux desdites double couches.

9. Appareil selon la revendication 8, dans lequel ledit élément optique comprend au moins six double couches et a une réflexion d'au moins 95% pour une lumière de 380nm de longueur d'onde.
